## Europäisches Patentamt
## European Patent Office
## Office européen des brevets

(11) Numéro de publication: **0 237 419
B1**

(12) # FASCICULE DE BREVET EUROPEEN

(45) Date de publication du fascicule du brevet:
**11.07.90**

(51) Int. Cl.⁵: **G08C 19/30,** G01R 11/24

(21) Numéro de dépôt: **87400480.7**

(22) Date de dépôt: **04.03.87**

(54) **Dispositif de télécomptage.**

(30) Priorité: **07.03.86 FR 8603271**

(43) Date de publication de la demande:
**16.09.87 Bulletin 87/38**

(45) Mention de la délivrance du brevet:
**11.07.90 Bulletin 90/28**

(84) Etats contractants désignés:
**AT BE CH DE ES GB IT LI NL SE**

(56) Documents cités:
**DE-A- 2 525 172
FR-A- 2 151 787
GB-A- 2 155 223
US-A- 4 357 601
US-A- 4 573 040**

(73) Titulaire: **ELECTRICITE DE FRANCE Service National, 2, rue Louis Murat, F-75008 Paris(FR)**
Titulaire: **SCHLUMBERGER INDUSTRIES, 50, avenue Jean Jaurès, F-92120 Montrouge(FR)**

(72) Inventeur: **Carnel, Alain, 162, Boulevard des Rocs, F-86000 Poitiers(FR)**

(74) Mandataire: **Polus, Camille et al, c/o Cabinet Lavoix 2, Place d'Estienne d'Orves, F-75441 Paris Cedex 09(FR)**

ACTORUM AG

## Description

L'invention concerne un dispositif de télécomptage par exemple utilisable pour transmettre à distance des informations relatives à une consommation volumétrique d'un fluide ou à une consommation d'énergie électrique (v. par exemple US-A 4 357 601).

Généralement de tels dispositifs comprennent des moyens de mesure d'une consommation, des moyens de transmission d'une valeur consommée, et des moyens de comptage, les moyens de transmission comprenant un contact normalement ouvert (ou normalement fermé) relié à une ligne de transmission bifilaire et dont la fermeture (ou l'ouverture) est commandée par un dispositif de mesure pour une valeur consommée prédéterminée.

Dans les dispositifs de télécomptage classiques d'une consommation de gaz, les moyens de mesure comprennent un totalisateur mécanique, par exemple un rouleau dont un tour correspond à un certain volume de gaz consommé. Les moyens de transmission comprennent, outre une ligne bifilaire, un modulateur prenant par exemple la forme d'une ampoule REED commandée à chaque tour complet du totalisateur mécanique, pour délivrer une information qui représente les incréments dans le temps dudit volume de gaz, et qui est transmise par l'intermédiaire de la ligne bifilaire, vers des moyens de comptage numérique. Ces dispositifs présentent l'inconvénient qu'ils ne permettent pas la surveillance de la ligne afin de détecter une éventuelle tentative de fraude ou une panne, soit par coupure de cette ligne, soit par mise en court-circuit.

Un des buts de l'invention est de réaliser un dipositif de télécomptage qui, tout en assurant sa fonction première, fournisse en outre périodiquement des indications sur l'état de la ligne reliant les moyens de modulation du signal de mesure aux moyens de comptage.

L'invention a donc pour objet un dispositif de télécomptage comprenant des moyens de mesure d'une consommation, des moyens de transmission d'information, propres à transmettre des informations relatives à des grandeurs consommées, et consistant essentiellement en des moyens de modulation et en une ligne bifilaire, et des moyens de comptage de ces informations disposés à l'autre extrémité de la ligne par rapport aux moyens de mesure, caractérisé en ce que lesdits moyens de modulation comprennent des moyens capacitifs reliés à la ligne bifilaire et des moyens de commutation qui sont actionnés par les moyens de mesure pour modifier corrélativement la valeur de la capacité totale que représentent, pour un signal circulant sur la ligne bifilaire, lesdits moyens capacitifs, et en ce que ce dispositif comprend en outre, du côté des moyens de comptage, un générateur de courant pour appliquer une impulsion de courant de charge sur la ligne bifilaire, et des moyens de détection reliés à la ligne et propres à distinguer, en fonction du temps de montée de la tension sur cette ligne en réponse à ladite impulsion de courant, au moins deux états des moyens de modulation et un état correspondant à une éventuelle coupure et/ou à un éventuel court-circuit des moyens de transmission.

Selon une caractéristique importante de l'invention, le temps de montée de la tension sur la ligne bifilaire est évalué par lesdits moyens de détection grâce à un échantillonnage de cette tension à au moins trois instants différents ($t_A$, $t_B$, $t_C$) prédéterminés par rapport à l'instant d'application de ladite impulsion de courant, et par comparaison des valeurs de tension ainsi échantillonnées à un seuil déterminé.

Un autre but de l'invention est de réaliser un dispositif de télécomptage qui puisse fonctionner de manière autonome lors d'une coupure d'alimentation pendant une période de temps importante.

L'invention a également pour objet un dispositif de télécomptage tel que défini ci-dessus et caractérisé en ce qu'il comprend un circuit d'alimentation autonome, et en ce qu'il comprend un circuit logique de réduction de la durée de l'impulsion de courant de charge et de l'alimentation des moyens de détection en cas de panne de secteur.

D'autres caractéristiques et avantages ressortiront de la description détaillée qui va suivre, donnée à titre d'exemple et faite en se référant aux dessins annexés sur lesquels :

- la Figure 1 est un schéma électrique du dispositif de télécomptage selon l'invention;
- la Figure 2 représente un schéma synoptique du dispositif, simplifié par rapport à la figure précédente;
- la Figure 3 représente un chronogramme de signaux pris en différents points du dispositif de la Figure 1, en fonctionnement avec une alimentation extérieure;
- la Figure 4 représente un chronogramme de signaux pris en différents points du dispositif de la Figure 1, en fonctionnement avec l'alimentation autonome; et
- la Figure 5 représente des diagrammes temporels de courant et de tension.

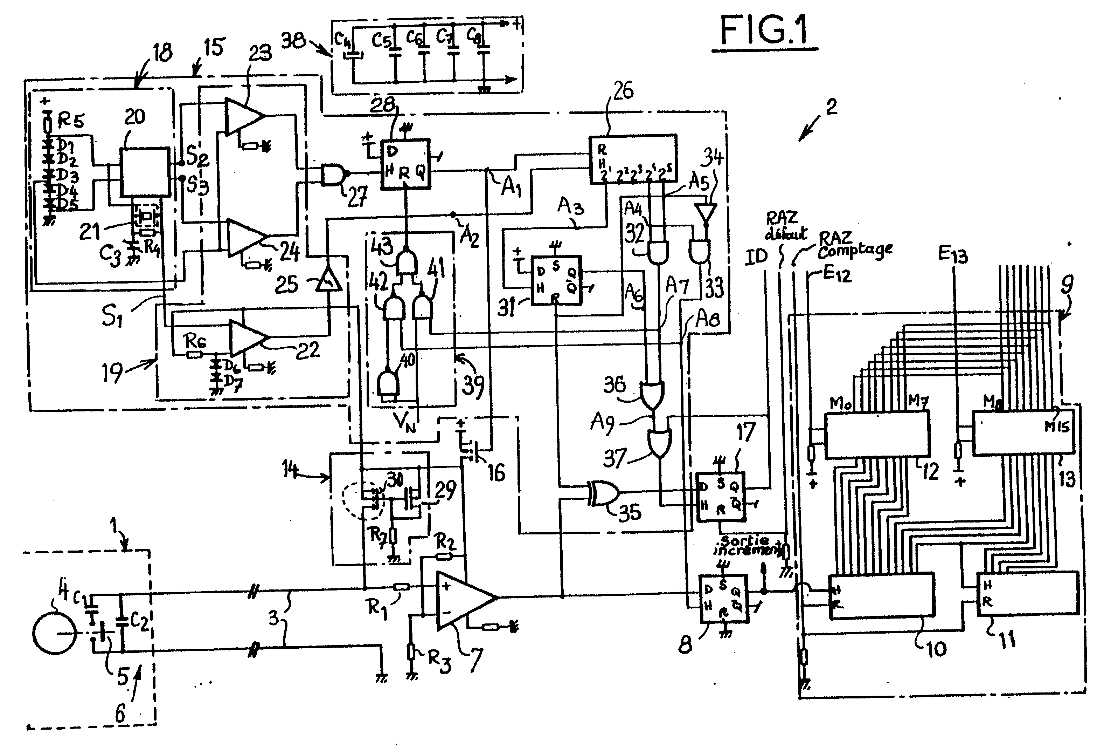

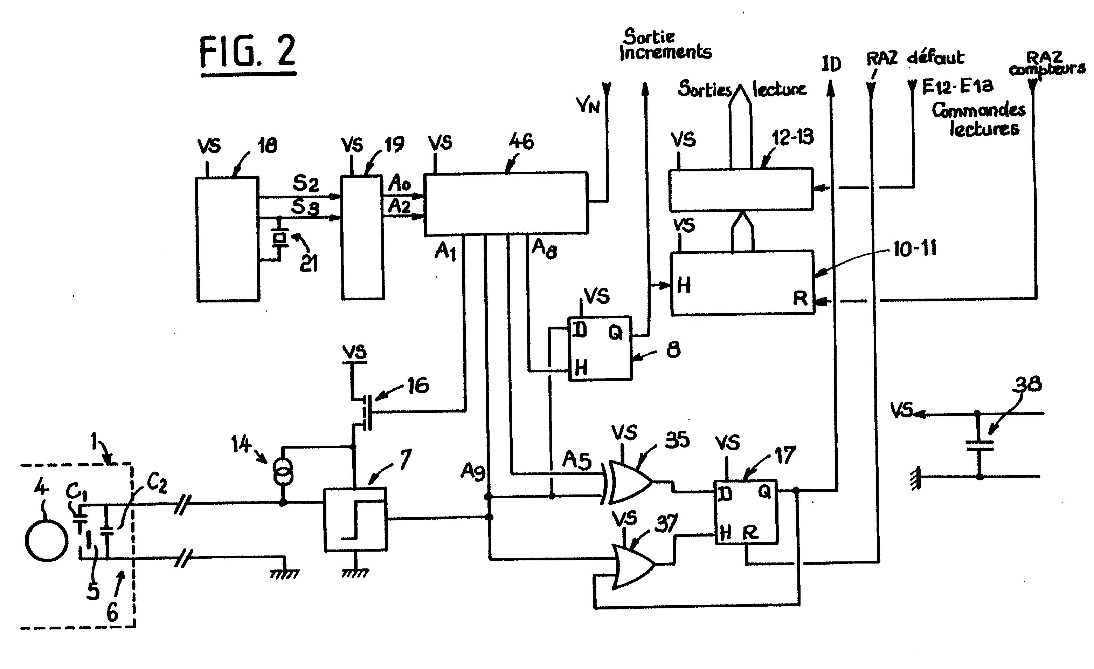

La Figure 1 représente la schéma électrique et la Figure 2 le schéma synoptique d'un dispositif de télécomptage comprenant un compteur de consommation 1 et des moyens de comptage éloignés 2 reliés au compteur 1 par une ligne bifilaire 3 permettant la transmission d'une information correspondant à une valeur consommée.

Le compteur 1, constituant un moyen de mesure, est schématisé par un rouleau 4 totalisateur de consommation qui commande l'ouverture et/ou la fermeture d'un contact 5, pour chaque tour de rouleau correspondant à une valeur consommée déterminée.

Le contact 5, constituant un moyen de commutation, est connecté en série avec un premier condensateur $C_1$, et un deuxième condensateur $C_2$ est monté en parallèle sur l'ensemble formé par ces deux éléments. Les deux bornes du condensateur $C_2$ sont chacune reliées à une extrémité des fils de la ligne bifilaire 3. Les condensateurs $C_1$, $C_2$ repérés globalement par la référence 6 constituent des moyens capacitifs. Les composants 3, 5 et 6 constituent des moyens de transmission, dont les quatre états possibles sont :
- ligne 3 coupée,
- contact 5 fermé,
- contact 5 ouvert,
- ligne 3 en court-circuit.

L'autre extrémité d'un des fils de la ligne 3 est reliée à la borne de masse d'un circuit d'alimentation 38, l'autre extrémité de l'autre fil étant reliée à l'entrée non-inverseuse d'un comparateur 7 à travers une résistance $R_1$. Le circuit d'alimentation 38 alimente l'ensemble du dispositif de télécomptage sous une tension continue $V_s$ de 3 à 5 volts. La borne d'alimentation du comparateur 7 est connectée à travers une résistance $R_2$ à l'entrée inverseuse de ce comparateur, cette dernière étant reliée à la borne de masse à travers une résistance $R_3$. Le comparateur 7 réalise donc une comparaison de la tension aux extrémités de la ligne 3 qu'il reçoit sur son entrée non-inverseuse, avec une tension de seuil; cette dernière est réglée, de manière connue, par le pont de résistances $R_2$, $R_3$, proportionnellement à la tension d'alimentation du comparateur 7, et appliquée sur l'entrée inverseuse de ce dernier.

La sortie de ce comparateur 7 est connectée à l'entrée D d'une bascule 8 dont la sortie Q est connectée à un circuit de comptage 9 constitué par deux compteurs numériques 10, 11 et deux circuits d'interface de lecture 12, 13. La sortie Q est connectée à l'entrée H du premier compteur 10 dont une sortie est connectée à l'entrée H du deuxième compteur 11. Les sorties de ces deux compteurs 10 et 11 sont reliées aux entrées de deux circuits d'interface 12 et 13 de telle manière que ces entrées reçoivent un nombre binaire de seize bits, correspondant au nombre compté de fermetures ou d'ouvertures du contact 5, et donc au nombre de fois la valeur consommée pour un tour du rouleau 4. Les huit premiers bits du nombre sont transmis au circuit d'interface 12 et les huit bits suivants, au circuit d'interface 13. Les sorties $M_0$ à $M_7$ du circuit 12 sont respectivement connectées aux sorties $M_8$ à $M_{15}$ du circuit 13 pour constituer les sorties du circuit de comptage 9. De cette manière, lorsqu'un signal de lecture est appliqué à la borne $E_{12}$ de commande du circuit 12, le contenu du compteur 10 peut être "lu" sur les sorties du circuit de comptage 9 et lorsqu'un signal de lecture est appliqué à la borne $E_{13}$ de commande du circuit 13, le contenu du compteur 11 peut être "lu" sur les sorties du circuit 9 et les compteurs peuvent être remis à zéro par l'entrée RAZ comptage reliée à leurs entrées R. Le circuit de comptage 9 est donc un circuit à seize bits permettant le comptage et la mémorisation d'un nombre allant de zéro à $2^{16}$, soit 65536. La lecture et le traitement des données peuvent être effectués, par exemple, par un microprocesseur.

La détection des quatre états des moyens de transmission 3, 5, 6 est effectuée par le comparateur 7 en fonction du temps de montée de la tension aux bornes de la ligne 3, en réponse à une impulsion de courant produite par un générateur de courant 14.

Ce temps de montée de la tension aux bornes de la ligne 3 est en effet dépendant de la valeur de la capacité totale de la ligne; or cette capacité diffère selon que la ligne est saine ou qu'elle est en défaut, par exemple coupée ou en court-circuit et, pour une ligne saine, cette capacité diffère également selon que les moyens de commutation 5 isolent le condensateur $C_1$ ou au contraire connectent ce condensateur en parallèle sur le condensateur $C_2$.

La sortie du générateur de courant 14 est connectée à l'extrémité du fil de la ligne qui correspond à l'entrée non-inverseuse du comparateur 7. Un circuit de commande périodique 15 d'un commutateur 16 du comparateur 7 et du générateur de courant 14, est destiné également au déclenchement séquentiel du comptage par l'intermédiaire de la bascule 8 et de l'indication de défaut dans les moyens de transmission 3, 5, 6 par l'intermédiaire d'une bascule 17.

Le circuit de commande 15 comprend un circuit de base de temps 18, un circuit de mise à niveau 19, et un circuit logique connectée au circuit d'alimentation du générateur de courant 14 et du comparateur 7 et aux bascules 8 et 17. Ce circuit logique sera décrit en détail ultérieurement.

Sur la figure 2, le séquenceur 46 correspond fonctionnellement au circuit de commande 15 privé du circuit de base de temps 18 et du circuit de mise à niveau 19.

Le circuit de base de temps 18 comprend un circuit intégré 20 dont deux bornes sont connectées à deux bornes d'un quartz 21 sur lequel est montée en parallèle une résistance $R_4$ dont une des bornes est reliée à la borne de terre à travers un condensateur variable $C_3$ et à la borne positive d'alimentation à travers une résistance $R_5$. L'autre borne de la résistance $R_4$ constitue une première sortie $S_1$ du circuit de base de temps et donne un signal périodique de fréquence fixe $f_1$. Les bornes d'alimentation du circuit intégré 20 sont connectées aux électrodes d'extrémité de cinq diodes $D_1$, $D_2$, $D_3$, $D_4$, $D_5$ polarisables à faible courant, montées en série, l'anode de la diode $D_1$ étant reliée à la borne positive d'alimentation $V_s$ à travers la résistance $R_5$ et la cathode de la diode $D_5$ étant connectée à la borne de terre. Deux sorties du circuit intégré 20 constituent respectivement une deuxième sortie $S_2$ et une troisième sortie $S_3$ du circuit de base de temps 18, qui fournissent deux signaux de même fréquence fixe $f_2$ et décalés d'une demi-période l'un par rapport à l'autre.

Les sorties $S_1$, $S_2$ et $S_3$ du circuit de base de temps sont reliées au circuit de mise à niveau 19 qui comprend trois amplificateurs opérationnels 22, 23 et 24, montés en comparateurs. On utilise dans ce circuit de mise à niveau des amplificateurs de technologie CMOS dont le courant de polarisation est ajustable par l'intermédiaire d'une résistance. La sortie $S_1$ est connectée à l'entrée non-inverseuse de l'amplificateur 22 dont l'entrée inverseuse est reliée, d'une part à la borne de terre à travers deux diodes $D_6$ et $D_7$ montées en série et d'autre part, à travers une résistance $R_6$, à sa borne d'alimentation et à l'émetteur du transistor d'alimentation 16 constituant le circuit d'alimentation. La sortie de l'amplificateur 22 est connectée à l'entrée d'un circuit de mise en forme 25 dont la sortie est reliée à l'entrée H d'un diviseur binaire 26. Les sorties $S_2$ et $S_3$ sont respectivement connectées aux entrées non-inverseuses des amplificateurs 23 et 24 dont les entrées inverseuses sont reliées ensemble au point de jonction des diodes $D_3$ et $D_4$ du circuit de base de temps. Les sorties des deux amplificateurs 23 et 24 sont connectées aux entrées d'une porte "NON-ET" 27 dont la sortie est connectée à l'entrée H d'une bascule 28. L'entrée D de cette bascule est reliée à la borne positive d'alimentation $V_s$ et sa sortie Q est reliée à l'entrée R du diviseur 26 d'une part et à la grille du transistor commutateur 16 d'autre part. Cette sortie Q applique à la base du transistor 16 une impulsion de durée $t_1$ à des intervalles de temps $T_1$, de sorte que le transistor est passant pendant la durée $t_1$ de l'impulsion et relie alors les bornes d'alimentation du comparateur 7 et du générateur de courant 14 à la borne positive d'alimentation. Le générateur de courant est composé de transistors montés en miroir de courant, c'est-à-dire d'un transistor image 29 ayant sa base connectée aux bases de cinq autres transistors 30 montés en parallèle (afin de simplifier la figure, un seul transistor a été représenté et entouré d'une ligne discontinue). Les source et substrat du transistor 29 sont connectés ensemble au collecteur du transistor 16 et son drain est relié d'une part à sa grille et aux grilles des cinq transistors 30 et d'autre part à la borne de masse à travers une résistance $R_7$. Les drains des cinq transistors 30 sont reliés ensemble au drain du transistor commutateur 16 et leurs drains sont connectés ensemble au fil de la ligne 3 qui correspond à l'entrée du comparateur 7.

Une première sortie $2^1$ du diviseur 26 est connectée à l'entrée H d'une bascule 31 dont l'entrée D est connectée à la borne positive de l'alimentation $V_s$.

Une deuxième sortie $2^4$ du diviseur est connectée à une des entrées d'une première 32 et d'une deuxième 33 portes "ET". Une troisième sortie $2^5$ du diviseur est connectée à l'entrée R de la bascule 31, à l'autre entrée de la première porte "ET" 32 et à l'entrée d'un module inverseur 34 dont la sortie est connectée à l'autre entrée de la deuxième porte "ET" 33. Cette troisième sortie est également connectée à une des entrées d'une porte "OU exclusif" 35 dont l'autre entrée est reliée à la sortie du comparateur 7 et dont la sortie est connectée à l'entrée D de la bascule 17 d'indication de défaut.

La sortie de la première porte "ET" 32 est connectée à une des entrées d'une porte "OU" 36 dont l'autre entrée est connectée à la sortie Q de la bascule 31 et dont la sortie est connectée à une des entrées d'une autre porte "OU" 37. L'autre entrée de la porte "OU" 37 est reliée à la sortie Q de la bascule 17 qui constitue la sortie d'indication de défaut ID. La sortie de la porte "OU" 37 est connectée à l'entrée H de la bascule 17 et la sortie de la deuxième porte "ET" 33 est connectée à l'entrée H de la bascule 8. La bascule 17 peut être remise à zéro, par l'entrée RAZ défaut reliée à son entrée R, après "lecture" de la sortie ID par un microprocesseur par exemple.

Avantageusement ce circuit de comptage 2 comprend un circuit 38 d'alimentation autonome $V_s$ permettant de sauvegarder la transmission du signal de consommation ainsi que le comptage de la valeur consommée, dans un fonctionnement avec une consommation d'énergie réduite.

Ce circuit doit permettre une autonomie d'au moins cent heures pendant lesquelles le télécomptage doit être assuré. Ainsi, le circuit d'alimentation comprend un condensateur $C_4$, d'une valeur d'environ un Farad, et de quatre condensateurs $C_5$ à $C_8$ connectés ensemble en parallèle. Ce circuit permet de maintenir la tension d'alimentation entre 5 et 3 volts pendant environ cent heures, la tension de 3 volts étant la tension minimale d'alimentation des circuits CMOS utilisés.

Une source auxiliaire (non représentée) de tension $V_N$ égale 5V, alimentée par le secteur, recharge les condensateurs du circuit d'alimentation autonome quand le secteur est présent.

Afin de réduire la consommation du circuit de télécomptage, la détection des défauts, dont le principe sera exposé plus loin lors de la description du fonctionnement du dispositif de télécomptage, n'est pas effectuée pendant le fonctionnement avec alimentation autonome. A cet effet, il est prévu un circuit logique 39 de réduction de la durée $t_1$ de l'impulsion de sortie de la bascule 28, en fonction du signal d'entrée $V_N$ indiquant la présence de l'alimentation secteur de la source auxiliaire. Ce signal est transmis aux deux entrées d'une première porte "NON-ET" 40 et à une des entrées d'une deuxième porte "ET" 41 dont l'autre entrée est connectée à la sortie de la première porte "ET" 32. La sortie de la première porte "NON-ET" 40 est connectée à une des entrées d'une troisième porte "NON-ET" 42 dont l'autre entrée est connectée à la sortie de la deuxième porte "ET" 33. Les sorties des deuxième 41 et troisième 42 portes "NON-ET" sont connectées respectivement aux entrées d'une quatrième porte "NON-ET" 43 dont la sortie est connectée à l'entrée R de la bascule 28.

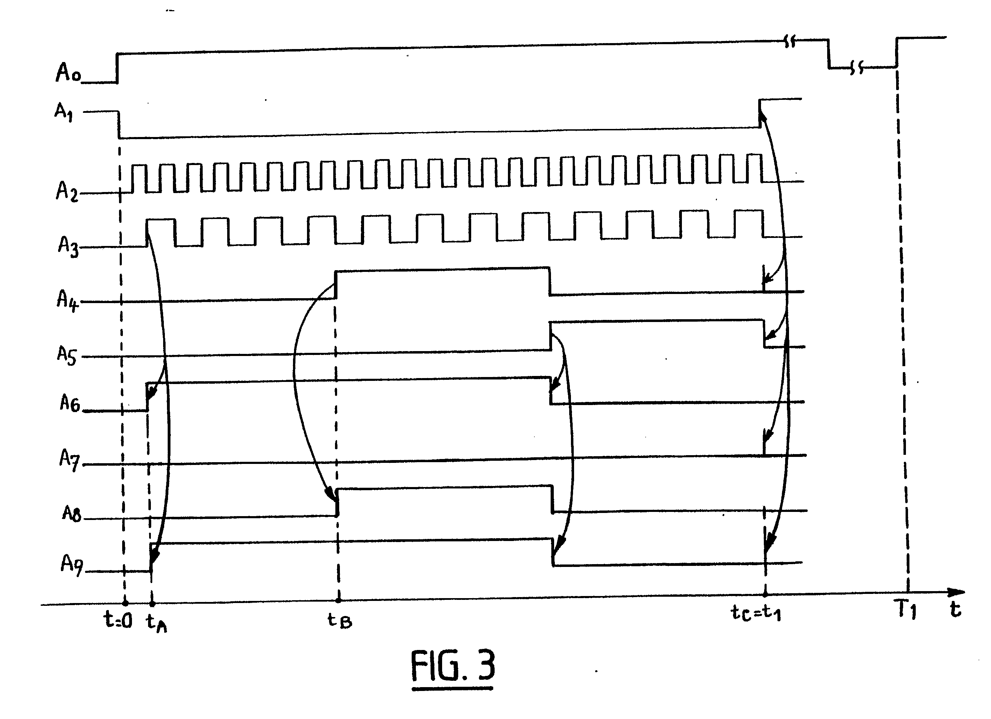

Le fonctionnement de ce dispositif de télécomptage va maintenant être décrit en se référant aux figures 3, 4 et 5 et pour un mode de réalisation particulier dans lequel on a utilisé les composants principaux suivants :

| Catégorie | Référence des composants | Caractéristiques |
|---|---|---|
| Diodes: | $D_1$ à $D_7$ | 1 N 4448 |
| Résistance: | $R_4$ | 10 M 5% 1/4 W |
| | $R_5$ | 1,5 M 5% 1/4 W |
| | $R_2$, $R_3$, $R_6$ | 1 M 5% 1/4 W |
| | $R_{10}$ | 1 K 5% 1/4 W |
| | $R_7$ | 4,64 K 1% 1/4 W |
| Quartz: | 21 | 32768 Hz |
| Circuits intégrés: | 20 | PCA 1201 |
| | 7, 22, 23, 24 | MO 409 |
| | 8, 17, 28, 31 | MC 114013 B |
| | 10, 11, 26 | MC 1 4040 B |
| | 12, 13 | 74 HC 244 |
| | 14, 16 (29, 30) | MO 405 |
| | 25, 27 | MC 14084 B |
| | 27, 32, 33 | MC 14081 B |
| | 34, 35 | MC 14070 B |
| | 36, 37 | MC 14071 B |
| Condensateurs: | $C_4$ | 1F 5,5 V |
| | $C_3$ variable | 4/40 pF |
| | $C_5$–$C_8$ | 47 nF 100 V ± 10% |

Avec le dispositif de télécomptage selon l'invention, le comptage et l'indication de défaut sont effectués en fonction de la valeur capacitive C des moyens capacitifs par comparaison de la tension aux bornes de la ligne 3 avec une tension seuil, pendant la durée $t_i$ de l'impulsion de courant fournie par le générateur de courant 14.

Si on appelle $C_C$ la capacité de la ligne 3, on peut définir quatre cas possibles d'état des moyens de transmission en fonction de leur capacité de sortie C :

- ligne coupée : $C=C_C$
- contact 5 fermé : $C=C_1+C_2=C_C$
- contact 5 ouvert : $C=C_2+C_C$
- ligne en court-circuit : la tension aux bornes de la ligne reste voisine de zéro.

On peut définir ainsi quatre temps de montée du signal E appliqué au comparateur 7, correspondant aux quatre cas précités et que l'on appellera respectivement $t_c$, $t_o$, $t_f$, $t_{cc}$.

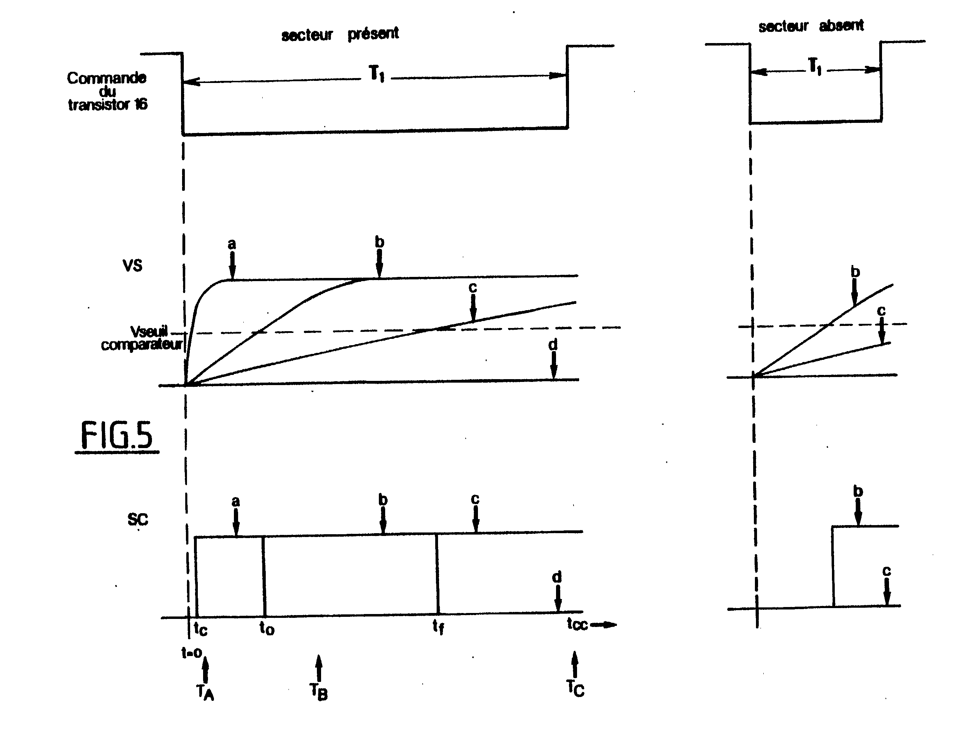

Sur la figure 5 sont représentés les tensions $V_1$ et $S_c$ à l'entrée et à la sortie du comparateur 7 dans les 4 cas cités, en présence et en l'absence de secteur.

Sur le tableau ci-après, on peut voir les valeurs de ces temps de montée (c'est-à-dire lorsque la tension $V_1$ à l'entrée du comparateur 7 devient supérieure à la tension de seuil V seuil de ce comparateur, voisine de Vs/2) pour un cable de trente mètres de long soit $C_C$=30x100pF=3nF au maximum, $C_1$=116nF et $C_2$=49nF. La valeur $t_{cc}$ (non représentée) est infinie.

Tableau I

| $C_{tot}$ (nF) | t nominal ($10^{-6}$s) | t minimal ($10^{-6}$s) | t maximal ($10^{-6}$s) | t échantillonnage ($10^{-6}$s) |
|---|---|---|---|---|
| 3 (Max) | $t_c$=7,5 | $t_c$=0 | $t_c$=12 | $t_A$=30 |
| 52 | $t_o$=130 | $t_o$=76 | $t_o$=207 | $t_o$=240 |
| 168 | $t_f$=420 | $t_f$=275 | $t_f$=617 | $t_c$=720 |

En fonctionnement sur secteur, le résultat de la comparaison pendant la durée $t_i$ de chaque impulsion est évalué séquentiellement trois fois pour déterminer les quatre états possibles des moyens de transmission.

En choisissant $t_i$=720.$10^{-6}$s et $T_1$=1s, les instants d'évaluation $t_A$, $t_B$, $t_C$ sont calculés à partir du début de l'impulsion et indiqués au tableau I. Cette prise en compte est réalisée par des stockages successifs du résultat (appelés par la suite "échantillonnages") dans l'une ou l'autre des bascules 8 et 17 au moyen du circuit de commande 15. Ces résultats seront analysés comme suit, toutes les secondes par exemple, par un microprocesseur :

- Premier échantillonnage à l'instant $t_A$ :

$V_1$ supérieur à V seuil = ligne coupée

- Deuxième échantillonnage à l'instant $t_B$:

$V_1$ supérieur à V seuil (avec $V_1$ inférieur à V seuil pour le premier)= contact ouvert

- Troisième échantillonnage à l'instant $t_C$:

$V_1$ supérieur à V seuil (avec $V_1$ inférieur à V seuil pour le premier et le deuxième) = contact fermé

$V_1$ inférieur à V seuil = ligne en court-circuit.

Avec ces valeurs particulières pour les capacités et les temps d'échantillonnage, on évite tout risque de chevauchement entre les différents temps et donc tout risque d'erreur dans l'analyse des résultats.

Les valeurs des instants $t_A$, $t_B$, $t_C$ sont calculées pour tenir compte des incertitudes de la tension de seuil, les capacités $C_1$, $C_2$, $C_3$ et le courant (valeurs minimales et maximales).

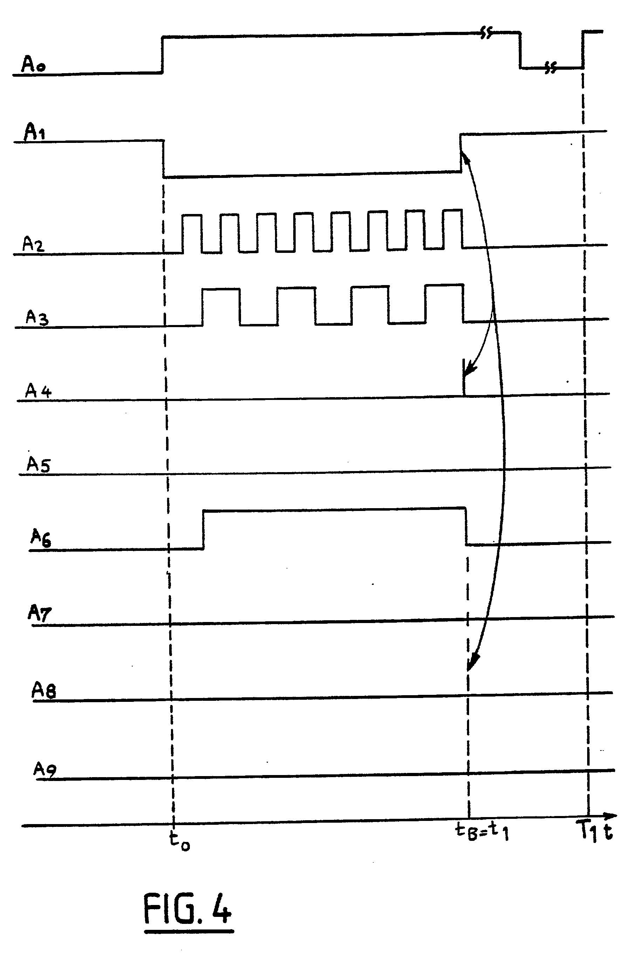

L'obtention de ces temps d'échantillonnage pour le stockage des informations de défaut et du comptage va maintenant être décrite en référence aux chronogrammes des Fig. 3 et 4 pour le fonctionnement avec alimentation par le secteur et avec alimentation autonome respectivement.

Le chronogramme de la Fig. 3 représente les signaux présents en différents points $A_0$ à $A_9$ du circuit de commande 15 (voir Fig.1) durant l'impulsion engendrée par les circuits 18, 19, 27 et 28. Le signal $A_0$ est le signal basse fréquence engendré par la base de temps 18 et mis en forme par le circuit 19. Le début du sigal $A_0$ est pris comme origine des temps t=o pour les diagrammes des figures 3 à 5. Le signal $A_1$ représente l'impulsion déclenchée par le signal $A_0$ à la sortie Q de la bascule 28 et qui est appliquée au transistor 16 de commutation du comparateur 7 et du générateur de courant 14. Pendant la durée $t_1$ de cette impulsion la sortie du comparateur applique donc la valeur de la comparaison $V_1$ par rapport à V seuil à l'entrée D de la bascule 8 et à l'entrée de la porte "OU exclusif" 35.

L'impulsion est également à l'entrée du compteur 26 qui reçoit un signal d'horloge $A_2$ d'environ 32 kHz. On obtient aux trois sorties utilisées du compteur 26, les signaux $A_3$, $A_4$, $A_5$ respectivement et, par l'intermédiaire de la bascule 31 et de la porte logique 32, les signaux intermédiaires $A_6$ et $A_7$.

Par l'intermédiaire des portes 33, 34 et 36 on obtient le signal $A_8$ qui sert à déclencher le deuxième échantillonnage au temps $t_B$ par la bascule 8 pour le comptage d'un incrément si le contact 5 est ouvert et le signal $A_9$ qui, combiné avec le signal d'indication de défaut par l'intermédiaire de la porte 37, sert à déclencher les premier et troisième échantillonnages aux temps $t_A$ et $t_C$ par la bascule 17, auquel cas le comptage n'aura pas de sens.

Le fonctionnement avec alimentation autonome va maintenant être décrit en se référant au chronogramme de la Figure 4.

L'impulsion $A_1$ à la sortie Q de la bascule 28 est déclenchée par le signal $A_0$ et sa durée est réduite à $t_B$ au moyen du circuit logique 39, en l'absence du signal d'alimentation secteur, de sorte que les signaux $A_5$, $A_7$ et $A_9$ restent à zéro. De cette manière les premier et troisième échantillonnages ne sont pas effectués par la bascule 17, tandis que le deuxième échantillonnage à lieu au temps $t_B$ grâce au signal $A_8$. Ainsi le comptage est effectué et le résultat est stocké dans les compteurs 10 et 11 qui pourront être "lus" par le microprocesseur, par exemple, à la fin de l'interruption d'alimentation secteur. Les compteurs 10 et 11, comme il a été indiqué précédemment, ont une capacité suffisante pour assurer le comptage pendant au moins cent heures.

Les circuits d'interface 12 et 13 permettent de connecter successivement les sorties des compteurs 10 et 11 à l'entrée du microprocesseur.

Ainsi qu'on le verra ci-après, la consommation d'énergie du dispositif de télécomptage selon l'invention a montré que l'alimentation autonome assure elle aussi le comptage durant au moins cent heures :

Consommation moyenne en fonctionnement avec alimentation secteur : $I=5 \ 10^{-6}A$

Consommation moyenne en fonctionnement autonome : en début de fonctionnement V=5V

$I=4,3 \ 10^{-6}A$

et en fin de consommation V=3V

$I=2,2 \ 10^{-6}A$

## Revendications

1. Dispositif de télécomptage comprenant des moyens (4) de mesure d'une consommation, des moyens de transmission d'information, propres à transmettre des informations relatives à des grandeurs consommées, et consistant essentiellement en des moyens de modulation et en une ligne bifilaire, et des moyens de comptage de ces informations, disposés à l'autre extrémité de la ligne par rapport aux moyens de mesure, caractérisé en ce que lesdits moyens de modulation comprennent des moyens capacitifs (6) reliés à la ligne bifilaire (3) et des moyens (2) de commutation (5) qui sont actionnés par les moyens de mesure (4) pour modifier corrélativement la valeur de la capacité totale que représentent, pour un signal circulant sur la ligne bifilaire, lesdits moyens capacitifs, et en ce que ce dispositif comprend en outre, du côté des moyens de comptage, un générateur de courant (14) pour appliquer une impulsion de courant de charge sur la ligne bifilaire, et des moyens de détection (7) reliés à la ligne (3) et propres à distinguer, en fonction du temps de montée de la tension sur cette ligne en réponse à ladite impulsion de courant, au moins deux états des moyens de modulation et un état correspondant à une éventuelle coupure et/ou à un éventuel court-circuit des moyens de transmission.

2. Dispositif suivant la revendication 1, caractérisé en ce que ledit temps de montée de la tension sur la ligne bifilaire est mesuré par lesdits moyens de détection grâce à un échantillonnage de cette tension à au moins trois instants différents ($t_A$, $t_B$, $t_C$) prédéterminés par rapport à l'instant d'application de ladite impulsion de courant, et par comparaison des valeurs de tension ainsi échantillonnées à un seuil déterminé.

3. Dispositif de télécomptage selon la revendication 1 ou 2 caractérisé en ce que la durée $t_1$ de l'impulsion de courant est égale à la durée d'alimentation des moyens de détection (7).

4. Dispositif de télécomptage selon l'une des revendications 1 à 3, caractérisé en ce que les moyens de détection sont constitués par un comparateur (7) relié aux bornes de la ligne bifilaire et dont la tension de seuil est fixée par l'intermédiaire du circuit d'alimentation (16) du générateur de courant et de ce comparateur.

5. Dispositif de télécomptage selon l'une quelconque des revendications 1 à 4, caractérisé en ce que les moyens de comptage sont constitués par un circuit de comptage (8, 9) et un circuit d'indication de défaut (17) reliés à la sortie du comparateur (7) et déclenchés séquentiellement durant chaque impulsion de courant par l'intermédiaire d'un circuit logique.

6. Dispositif de télécomptage selon l'une quelconque des revendications 1 à 5, caractérisé en ce qu'il comprend un circuit (38) d'alimentation autonome, et des moyens (39) pour réduire l'impulsion de courant de charge en cas de panne de secteur.

7. Dispositif de télécomptage selon les revendications 5 et 6, caractérisé en ce qu'en mode de fonctionnement autonome, le circuit logique ne déclenche que le circuit de comptage (8, 9).

## Patentansprüche

1. Fernzählvorrichtung mit Einrichtungen (4) zum Messen eines Verbrauchs, Informationsübertragungseinrichtungen, die Informationen über verbrauchte Größen übertragen können und im wesentlichen aus Modulationseinrichtungen und einer zweiadrigen Leitung (3) bestehen, und Einrichtungen (2) zum Zählen dieser Informationen, die bezüglich den Meßeinrichtungen am anderen Ende der Leitung angeordnet sind, dadurch gekennzeichnet, daß die Modulationseinrichtungen kapazitive Einrichtungen (6), die mit der zweiadrigen Leitung verbunden sind, und Umschalteinrichtungen (5) besitzen, die durch die Meßeinrichtungen (4) betätigt werden, um korrelativ den Wert der gesamten Kapazität zu ändern, die die kapazitiven Einrichtungen bei einem auf der zweiadrigen Leitung auftretenden Signal darstellen, und daß die Vorrichtung ferner auf der Seite der Zähleinrichtungen einen Stromgenerator (14), der an die zweiadrige Leitung Ladestromimpulse anlegt, und Abtasteinrichtungen (7) besitzt, die mit der Leitung (3) verbunden sind und in Abhängigkeit von der Zeit des Anstiegs der Spannung auf dieser Leitung infolge des Stromimpulses mindestens zwei Zustände der Modulationseinrichtungen und einen Zustand unterscheiden können, der einer möglichen Unterbrechung und/oder einem möglichen Kurzschluß der Übertragungseinrichtungen entspricht.

2. Vorrichtung nach Anspruch 1, dadurch gekennzeichnet, daß die Zeit des Anstiegs der Spannung in der zweiadrigen Leitung durch die Abtasteinrichtungen gemessen wird, indem diese Spannung an mindestens drei verschiedenen Zeitpunkten ($t_A$, $t_B$, $t_C$) abgetastet wird, die bezüglich des Zeitpunkts des Anlegens des Stromimpulses festgelegt sind, und die abgetasteten Spannungswerte mit einer bestimmten Schwelle verglichen werden.

3. Fernzählvorrichtung nach Anspruch 1 oder 2, dadurch gekennzeichnet, daß die Dauer ($t_1$) des Stromimpulses gleich der Speisedauer der Abtasteinrichtungen (7) ist.

4. Fernzählvorrichtung nach einem der Ansprüche 1 bis 3, dadurch gekennzeichnet, daß die Abtasteinrichtungen aus einem Vergleicher (7) bestehen, der mit den Anschlüssen der zweiadrigen Leitung verbunden ist und dessen Schwellenspannung über den Versorgungskreis (16) des Stromgenerators und des Vergleichers festgelegt ist.

5. Fernzählvorrichtung nach einem der Ansprüche 1 bis 4, dadurch gekennzeichnet, daß die Zähleinrichtungen aus einer Zellschaltung (8, 9) und einer Fehleranzeigeschaltung (17) bestehen, die mit dem Ausgang des Vergleichers (7) verbunden sind und sequentiell während jedes Stromimpulses über eine logische Schaltung ausgelöst werden.

6. Fernzählvorrichtung nach einem der Ansprüche 1 bis 5, gekennzeichnet durch eine selbständige Versorgungsschaltung (38) und Einrichtungen (39) zur Verringerung des Ladestromimpulses im Fall einer Netzstörung.

7. Fernzählvorrichtung nach den Ansprüchen 5 und 6, dadurch gekennzeichnet, daß die logische Schaltung in der selbständigen Betriebsweise nur die Zählschaltung (8, 9) auslöst.

## Claims

1. Device for remote metering, comprising means (4) for measuring a consumption, means for transmitting information, which transmission means are suitable for transmitting information relating to quantities consumed, and consisting essentially of modulating means and of a bifilar line (3), and means (2) for counting these sets of information, which counting means are disposed at the other end of the line in relation to the measuring means, characterized in that the said modulating means comprise capacitive means (6) connected to the bifilar line and switching means (5) which are actuated by the measuring means (4) to modify correlatively the value of the total capacitance which is represented, for a signal passing along the bifilar line, by the said capacitive means, and in that this device further comprises, on the counting means side, a current generator (14) to apply a load current pulse to the bifilar line, and detecting means (7) which are connected to the line (3) and which are suitable for distinguishing, as a function of the rise time of the voltage on this line in response to the said current pulse, at least two states of the modulating means and one state corresponding to possible cutting and/or to a possible short-circuit of the transmission means.

2. Device according to claim 1, characterized in that the said rise time of the voltage on the bifilar line is measured by the said detecting means by a sampling of this voltage at at least three different instants ($t_A$, $t_B$, $t_C$) which are predetermined in relation to the instant of application of the said current pulse, and by comparison of the voltage values thus sampled with a determined threshold.

3. Device for remote metering according to claim 1 or 2, characterized in that the duration $t_1$ of the current pulse is equal to the duration of supply of the detecting means (7).

4. Device for remote metering according to one of claims 1 to 3, characterized in that the detecting means are constituted by a comparator (7) which is connected to the terminals of the bifilar line and the threshold voltage of which is fixed by means of the supply circuit (16) of the current generator and of this comparator.

5. Device for remote metering according to any one of claims 1 to 4, characterized in that the counting means are constituted by a counting circuit (8, 9) and a circuit for fault indication (17), which are connected to the output of the comparator (7) and triggered sequentially during each current pulse by means of a logic circuit.

6. Device for remote metering according to any one of claims 1 to 5, characterized in that it comprises an independent supply circuit (38) and means (39) for reducing the load current pulse in the event of mains failure.

7. Device for remote metering according to claims 5 and 6, characterized in that, in the independent operational mode, the logic circuit triggers only the counting circuit (8, 9).

FIG.1

# FIG. 2

EP 0 237 419 B1

FIG. 3

EP 0 237 419 B1

FIG. 4

**FIG.5**

secteur présent

secteur absent

Commande du transistor 16

$T_1$

VS

Vseuil comparateur

a · b · c · d

SC

a · b · c · d

$t_c$ · $t_o$ · $t_f$ · $t_{cc}$ →

t=0

$T_A$ · $T_B$ · $T_C$

EP 0 237 419 B1